**Europäisches Patentamt**

**European Patent Office**

**Office européen des brevets**

(19)

(11) Veröffentlichungsnummer: **0 126 171**
**B1**

(12)

# EUROPÄISCHE PATENTSCHRIFT

(45) Veröffentlichungstag der Patentschrift:
**07.01.87**

(21) Anmeldenummer: **83104957.2**

(22) Anmeldetag: **19.05.83**

(51) Int. Cl.⁴: **H 05 K 3/22**

(54) **Verfahren zur ganzflächigen Nacharbeitung von Mehrlagenschaltungen mit fehlerhaften äusseren Kupferleiterzügen.**

(43) Veröffentlichungstag der Anmeldung:
**28.11.84 Patentblatt 84/48**

(45) Bekanntmachung des Hinweises auf die Patenterteilung:
**07.01.87 Patentblatt 87/2**

(84) Benannte Vertragsstaaten:
**DE FR GB**

(56) Entgegenhaltungen:
**EP - A - 0 043 586**
**DE - A - 2 309 196**
**DE - A - 2 847 070**
**DE - C - 1 812 692**
**US - A - 3 753 816**

(73) Patentinhaber: **IBM DEUTSCHLAND GMBH,**
**Pascalstrasse 100, D-7000 Stuttgart 80 (DE)**

(84) Benannte Vertragsstaaten: **DE**

(73) Patentinhaber: **International Business Machines**
**Corporation, Old Orchard Road, Armonk,**
**N.Y. 10504 (US)**

(84) Benannte Vertragsstaaten: **FR GB**

(72) Erfinder: **Schwerdt, Friedrich, Nelkenstrasse 23,**
**D-7033 Herrenberg 1 (DE)**
Erfinder: **Mueller, Harald, Lerchenweg 24,**
**D-7031 Grafenau 1 (DE)**

(74) Vertreter: **Kreidler, Eva-Maria, Dr. rer. nat., Schönaicher**
**Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur ganzflächigen Nacharbeitung von Mehrlagenschaltungen mit fehlerhaften äusseren Kupferleiterzügen.

Die Technologie bei der Herstellung von Mehrlagenschaltungen ist im Zuge der Miniaturisierung elektronischer Bauteile und ihrer damit verbundenen erhöhten Packungsdichte ständig weiterentwickelt worden. Zum allergrössten Teil werden Mehrlagenschaltungen oder Multilayer nach dem heutigen Stand der Technik schrittweise durch Zusammenfügen von Kupferfolien und Isolierschichten durch Laminieren hergestellt. Da es technisch schwierig ist, beispielsweise 20 Lagen aus Kupferfolie und 60 Isolierschichten in einem Arbeitsgang zu einer Leiterplatte zusammenzufügen, stellt man zunächst einzelne Baugruppen — sogenannte Zwischenlaminate — her und setzt aus diesen die Mehrlagenschaltung zusammen.

Zur Herstellung der Grundbaugruppen des Energiekerns werden auf einigen Lagen Prepreg, welches eine Isolierschicht aus mit Epoxidharz getränktem Glasfasergewebe ist, die, um weiter verarbeitbar zu bleiben, nicht vollständig ausgehärtet ist, beidseitig Kupferfolien von etwa 35 µm Dicke auflaminert. In einem subtraktiven Photoätzprozess werden die Kupferschichten in den durch Photoresist nicht abgedeckten Bereichen abgeätzt, so dass nach dem Entfernen des Photoresists auf der Isolierschicht nur noch die gedruckte Schaltung verbleibt.

Auf dem Energiekern baut eine Baugruppe mit Signalebenen auf. Hierzu werden auf diesen beidseitig einige Lagen Prepreg und auf diese wiederum jeweils eine zweischichtige Kupferfolie auflaminert. Nach dem Abziehen der Trägerfolie verbleibt beidseitig eine etwa 5 µm dicke Kupferschicht. Auf die Kupferschicht wird ein Photoresistfilm auflaminert und in üblicher Weise über eine Maske belichtet. Beim Entwickeln wird der Photoresistfilm an denjenigen Stellen aufgelöst, an denen die Kupferleiterzüge entstehen sollen. Durch semiadditives Verkupfern in einem Kupferbad wächst auf dem freigelegten Kupfer, das dem gewünschten Leiterzugmuster entspricht, weiteres Kupfer chemisch auf, wobei die Höhe der Leiterzüge durch die Verweilzeit im Bad bestimmt werden kann. Zum Schutz der Kupferleitzüge wird anschliessend chemisch eine Zinnschicht aufgebracht. Dann wird die Photoresistmaske entfernt. Im nun folgenden Ätzprozess wird die dünne Kupferfolie in denjenigen Bereichen, wo sich keine mit Zinn geschützten Leiterzüge befinden, abgeätzt, und anschliessend wird die Zinnschicht wieder entfernt.

In einem weiteren Prozessschritt bringt man auf das Laminat beidseitig weitere Isolierebenen und anschliessend wiederum eine 5 µm dicke Kupferfolie auf. Dann wird in einem Photoätzprozess überall dort, wo Löcher zur Verbindung jeweils zweier Signalebenen entstehen sollen, das Kupfer weggeätzt. Im folgenden Prozessschritt bohrt ein Laserstrahl Löcher durch die Isolierschicht zur tiefer liegenden Signalebene, an der er reflektiert wird, so dass Sacklöcher mit genau definierter Bohrtiefe erhalten werden. Anschliessend werden auf jeder Seite des Laminats in einem Photoätzprozess und durch semiadditives Verkupfern die Signalleitungen aufgebracht unter gleichzeitiger Verkupferung der gebohrten Löcher. Das Ergebnis dieser Prozessabfolge ist eine fertige Zwischenkomponente aus einem Energiekern und vier Signalebenen.

Weitere Zwischenkomponenten werden in analoger Weise hergestellt. In einem letzten Laminiervorgang werden alle Komponenten, sowie die Kupferfolien für die Modulebene, welche die oberste Lage der Mehrlagenschaltung ist und für die Verdrahtungsebene, welche der zusätzlichen äusseren Verdrahtung dient, zusammenlaminert. Zum Verbinden der einzelnen Lagen untereinander werden in die Leiterplatten Löcher gebohrt. Nach dem Bohren werden auf der 5 µm Kupferfolie in einem semiadditiven Verfahren die äusseren Schaltungen der Leiterplatte aufgebracht. Dabei werden auch die Bohrlöcher mitverkupfert. Mit diesem Prozessschritt ist eine Mehrlagenschaltung fertiggestellt.

Bei der zuvor beschriebenen Herstellung von Leiterplatten kommt es gelegentlich, z.B. beim Belichten oder Ätzen zu Fehlern, die zu Unterbrechungen in den Leiterzügen führen.

Zur Reparatur von schmalen Leiterzügen (100 µm Breite und darunter) wurde in einem in der deutschen Auslegeschrift 2 251 997 beschriebenen Verfahren vorgeschlagen, die Fehlstellen mittels eines ein eutektisches Material tragenden Feinbandes zu überbrücken und dieses unter Einhaltung eines auf höchstens 10 ms begrenzten Stromimpulses und bei einer Elektrodenspannung von weniger als 1 Volt durch Hartlöten mit dem Leiterzug zu verbinden.

In der Europäischen Patentanmeldung 43 586 ist eine Vorrichtung zur Reparatur von Leiterbahnunterbrechungen beschrieben, mit der gleichzeitig mit der Verschweissung eines Reparaturbandes mit den unterbrochenen Leiterbahnen eine lagerichtige Positionierung der zu verschweissenden Teile ermöglicht wird. Für den Schweissvorgang des spezifischen Formteils aus einem Folienband beidseitig einer Leiterbahnunterbrechung ist laut der Europäischen Patentanmeldung ein dreiteiliges Elektrodensystem vorgesehen, das aus einer zentrischen, mit einem Vakuumanschluss zum Ansaugen des Formteils ausgestatteten Innenelektrode besteht, um die konzentrisch zwei halbkreisförmige Aussenelektroden sitzen. Die Elektroden sind jeweils durch einen Luftspalt elektrisch voneinander getrennt und ferner unabhängig voneinander mechanisch gefedert. Mit dieser Vorrichtung wird erreicht, dass gleichzeitig die Innenelektrode mittels Saugluft das Formteil übernehmen und damit zur Positionierung beitragen kann.

Beim Auftreten von mehreren Fehlern in der äusseren Verdrahtungsebene sind die zuvor beschriebenen Verfahren vom Standpunkt der Wirtschaftlichkeit aus nicht mehr durchführbar. Bisher ist jedoch kein Verfahren bekannt, mit dem es möglich ist, Fehler in den äusseren Verdrahtungsebenen durch einen ganzflächigen Nacharbeitungsprozess unter Anwendung additiver Metallabscheidung zu eliminieren. Als Grundlage eines jeden additiven Metallabscheideverfahrens muss eine Aktivierungsschicht, z.B. eine dünne Kupferfolie auf das Expoxidharz-Prepreg aufgebracht werden, auf der dann nach bekannten Verfahren in den durch Photoresist begrenzten Bereichen Leiterzüge aufwachsen. In gleicher Weise müsste beim Nacharbeiten einer Mehrlagenschaltung, die Fehler in der äusseren Verdrahtung zeigt, nach dem Abätzen der Leiterzüge eine haftungsvermittelnde Kupferfolie neu auflaminiert werden. Erfahrungsgemäss ist es aber unmöglich, auf ein abgeätztes, ausgehärtetes Epoxidharzsubstrat eine Kupferfolie neu aufzulaminieren. Dies wäre nur unter Zuhilfenahme eines vorvernetzten Epoxidharz-Prepregs möglich. Dann müsste aber die Mehrlagenschaltung neu gebohrt werden, wobei die Bohrer genau auf die alten Bohrungen treffen müssten, um Bohrerbruch zu vermeiden. Die hierzu erforderliche Justage ist in diesem Stadium nicht mehr durchführbar, so dass Mehrlagenschaltungen mit fehlerhaften äusseren Kupferleiterzügen bisher als irreparabel verschrottet werden mussten.

Aufgabe der Erfindung ist, ein Verfahren anzugeben, mit dem Mehrlagenschaltungen mit fehlerhaften äusseren Kupferleiterzügen ganzflächig nachgearbeitet und die Mehrlagenschaltungen, die von hohem Wert sind, wieder in den Prozess zurückgeführt werden können.

Diese Aufgabe wird gemäss der Erfindung gelöst durch die Massnahmen, die in Patentanspruch 1 niedergelegt sind.

Der besondere Vorteil des Verfahrens gemäss der Erfindung liegt darin, dass Mehrlagenschaltungen mit fehlerhaften äusseren Kupferleiterzügen nachgearbeitet werden können, um in den Prozess rückgeführt zu werden.

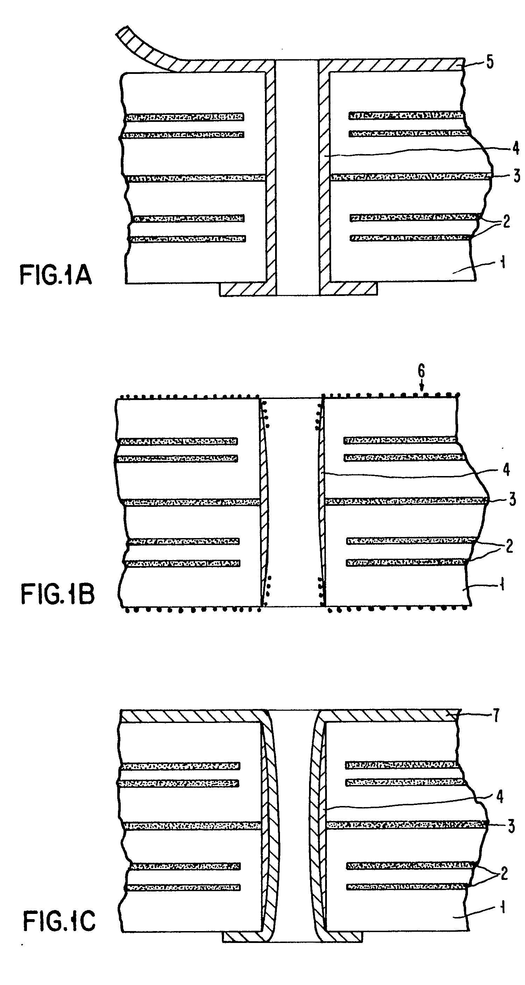

Die Erfindung wird anhand der nachfolgenden speziellen Beschreibung und der Figuren 1A bis 1C näher erläutert.

Die Figuren 1A bis 1C zeigen Ausschnitte aus einer Mehrlagenschaltung in den verschiedenen Stadien der Bearbeitung nach dem erfindungsgemässen Verfahren.

Das Nacharbeitverfahren gemäss der Erfindung beruht darauf, dass die Kupferleiterzüge der äussersten Ebenen unter genau definierten Bedingungen abgeätzt werden. Die Ätzbedingungen werden dabei so gewählt, dass der Ätzangriff an den Bohrlochwandungen wesentlich schwächer ist als an den äusseren Kupferleiterzügen. Dadurch wird das Kupfer der Bohrlochwandungen nicht vollständig zurückgeätzt, und der verbleibende Teil bildet einen Ätzschutz für die inneren Leiterzugebenen. Ein weiteres wichtiges Merkmal ist das Aufbringen einer wirksamen Aktivierungsschicht durch Aufsputtern von Kupfer auf die abgeätzte Epoxidharzoberfläche der Leiterplatte. Auf dieser aufgesputterten Kupferschicht können dann nach bekannten photolithographischen Verfahren die vorher fehlerhaften Leiterzugstrukturen neu hergestellt werden.

*Ausführungsbeispiel:*

Bei dem Nacharbeitprozess gemäss der Erfindung wird von einer Mehrlagenschaltung, die aus einem Epoxidharzkern 1 mit eingelegten Signalebenen 2 und Signalebenen 3 besteht, wobei letztere mit verkupferten Bohrlöchern verbunden sind, ausgegangen. In der äussersten Lage der Mehrlagenschaltung befinden sich beispielsweise Kupferleiterzüge 5, welche schlecht auf dem Epoxidharzsubstrat haften.

Auf der Oberfläche der Mehrlagenschaltung ist weder eine Photoresistfolie noch Lötstopplack aufgetragen. Um die fehlerhaften Leiterzüge 5 gleichmässig abätzen zu können, ist es erforderlich, die Mehrlagenschaltung, wie nachfolgend angegeben, zu behandeln. Es ist auch erforderlich, Kupferoxid sorgfältig zu entfernen, welches auf die Ätzung hemmend wirkt.

1. Die Mehrlagenschaltung wird zunächst mit einem alkalischen Reinigungsmittel gereinigt. Hierzu ist beispielsweise ein Reinigungsmittel auf der Basis von Natrium-m-silicat mit einem Gehalt an Laurylsulfatnatrium und Diglykol, welches unter der Bezeichnung Pennsalt K2 im Handel erhältlich ist, geeignet. Man lässt vorteilhafterweise eine Lösung mit einem Gehalt von 45 bis 60 g pro Liter Pennsalt K2 etwa 2 Minuten lang bei einer Temperatur von 65°C auf die Mehrlagenschaltung einwirken. Hierbei findet eine Entfettung der Oberfläche statt.

2. Nach diesem Schritt findet während 1 Minute ein Standspülen mit deionisiertem Wasser statt und anschliessend eine Behandldung in einer Fliessspüle während 2 Minuten bei einem Durchsatz von etwa 2000 Liter pro Stunde.

3. Zur Entfernung des Kupferoxids lässt man anschliessend eine 25 Vol.%ige Chlorwasserstoffsäure einwirken.

4. Daran anschliessend folgt ein Fliessspülen wie unter Punkt 2, das wiederholt wird.

5. Nunmehr werden die fehlerhaften Leiterzüge in einem salzsauren Kupfer-II-chloridbad bei Zimmertemperatur abgeätzt. Das Bad enthält etwa 27 g/l Kupfer-II-chlorid und 220 g/l HCl (32 Gew.-%). Während des Ätzens perlt Luft vom Boden der Wanne durch das Bad, ausserdem findet eine alternierende Bewegung der Mehrlagenschaltungen statt. Es ist sehr wichtig, dass die Mehrlagenschaltungen zum Ätzen in der Weise in einer Halterung in das Bad eingefahren werden, dass die gebohrten Durchgangslöcher der Mehrlagenschaltung im rechten Winkel zur alternierenden Bewegungsrichtung der Schaltung und zur Badströmungsrichtung orientiert sind. Dadurch wird erreicht, dass die Kupferätzrate an den äusseren Leiterzugebenen im Bereich von etwa 1,5 bis 2 µm/Min. liegt, während sie zur Mitte der Bohrung hin kontinuierlich bis fast auf 0 abfällt. Wenn die Ätzung in dieser Weise durchgeführt wird, wird ein Profil 4 des Kupfers an den Bohrungswandungen erhalten, wie es aus Fig. 1B ersichtlich ist. Durch das aus den Bohrungswandungen verbleibende Kupfer werden die inneren Leiterzugebenen 3 vor einem Ätzangriff geschützt, wodurch die Gefahr einer irreparablen Rückätzung der inneren Leiterzugebenen 3 ausgeschlossen wird. Das Ätzen in der salzsauren Kupferchloridlösung wird so lange fortgesetzt, bis alle äusseren Leiterzugebenen 5 restlos abgeätzt sind.

Von grosser Bedeutung für die Rückätzung des Kupfers an den Bohrungswandungen ist auch der Gehalt der Ätzlösung an $CuCl_2$. Es hat sich gezeigt, dass bei einem Gehalt der Ätzlösung an $CuCl_2 > 40$ g/l die Rückätzung in den Bohrungen zu gross wird, während bei einem Gehalt von

< 15 g/l die Ätzraten zu klein werden und dadurch eine ungleichmässige Ätzung stattfindet.

6. Der nächste Schritt umfasst ein Fliessspülen in deionisiertem Wasser wie unter Punkt 4.

7. Die Mehrlagenschaltungen werden im Warmlufttrockenschrank bei etwa 80°C getrocknet.

8. Bei einer Inspektion unter dem Stereomikroskop müssen alle Kupferhülsen 4 in den Bohrlöchern (Fig. 1B) noch einwandfrei erkennbar sein. Die Rückätzung der Kupferhülse beträgt an der Ober- und Unterseite der Mehrlagenschaltung etwa 150 bis 200 μm, was etwa dem halben Bohrlochdurchmesser entspricht.

Das Aufbringen der Aktivierungsschicht 6 (Fig. 1B) für den neuen Additivprozess wird vorteilhafterweise in einer Magnetron-Kupfersputteranlage durchgeführt. Die Parameter für das Aufbringen der Aktivierungsschicht in der Anlage sind folgende:

Evakuieren der Anlage auf etwa $2 \times 10^{-5}$ mbar;

Argonpartialdruck: $2\text{-}3 \times 10^{-3}$ mbar;

Substrattemperatur: 80 bis 90°C (Thermopunktmessung);

Substratbewegung: 2-3 cm sec$^{-1}$ auf einer Transporteinrichtung;

Sputterrate: 1,0 bis 1,5 nm/s;

Dicke der Aktivierungsschicht: etwa 200-500 nm.

Dieses Verfahren lässt sich in Sputterdurchlaufanlagen vollautomatisch gestalten, wobei in diesen Anlagen das gleichzeitige Besputtern von Vorder- und Rückseite der Mehrlagenschaltung durch zwei Kathoden möglich ist. Mit den zuvor angegebenen Verfahrensparametern kann beim Sputtern ein Aspektverhältnis, d.h. Ein Verhältnis des Durchmessers des Bohrlochs zu seiner Tiefe von etwa 1:3 erreicht werden. Dies bedeutet, dass ein Bohrloch mit etwa 0,4 mm Durchmesser beim Sputtern bis zu einer Tiefe von etwa 1,2 mm verkupfert wird. Wie zuvor beschrieben, beträgt die Rückätzung der Kupferhülse im Bohrloch maximal nur 0,2 mm, so dass eine einwandfreie Kupferüberlappung an der Bohrlochwandung gewährleistet ist.

Auf die aufgesputterte Kupferschicht 6 (Fig. 1B) wird in bekannter Weise eine Photoresistschicht aufgetragen und in einem photolithographischen Prozess strukturiert (nicht dargestellt). In den durch die Resistmaske nicht bedeckten Bereichen wachsen auf der Kupferschicht 6 Leiterzüge 7 additiv auf; gleichzeitig werden die Bohrlochwandungen mitverkupfert. Zur Verkupferung kann ein Bad mit den nachfolgenden Betriebsdaten verwendet werden:

| | |
|---|---|
| pH-Wert | 12,6 eingestellt mit NaOH |
| CuSO$_4 \times$ 5 H$_2$O: | 10,5 g/l hochreines Kupfersalz |
| HCHO (37%ig): | 3,5 ml/l als Reduktionsmittel |
| NaCN: | 26 mg/l als Duktilitätsförderer |
| EDTA: | 17,5 g/l als Komplexierungsmittel |
| Temperatur: | 53 ± 1°C. |

Auf der aufgesputterten Kupferschicht 6 haftet additiv abgeschiedenes Kupfer 7 sehr gut, weil, wie eingangs ausführlich geschildert, zur Herstellung der ursprünglich vorhandenen Leiterzüge eine Kupferfolie auflaminiert wurde. Diese Kupferfolie hatte, bedingt durch ihre Dendritenstruktur, die Laminationsoberfläche stark aufgerauht, wodurch auch jetzt eine gute Kupferhaftung gewährleistet wird. Die folgenden Prozessschritte des Verzinnens, der Entfernung der Photoresistmaske und des aufgesputterden Kupfers in den Bereichen, in denen sich keine Leiterzüge befinden, werden in bekannter Weise vorgenommen.

Proben, die gemäss diesem Verfahren nachgearbeitet worden waren, zeigten in einem nassthermischen Test, bei dem die Mehrlagenschaltung in Wasser von 0 bis 100°C getaucht wird, keinerlei Spannungsrisse an den Kupfergrenzflächen zwischen altem und neu aufgebrachtem Kupfer in den Bohrlöchern. Mit dem erfindungsgemässen Verfahren, welches in einfacher und gut kontrollierbarer Weise durchführbar ist, wird erstmalig eine ganzflächige Nacharbeitmöglichkeit an Mehrlagenschaltungen mit fehlerhaften äusseren Kupferleiterzügen vorgestellt, wodurch Teile von hoher Wertschöpfung wieder in den Prozess rückgeführt werden können.

**Patentansprüche**

1. Verfahren zum Erneuern fehlerhafter Kupferleiterzüge (5) auf den äusseren Ebenen von ein Substrat (1) und Bohrlöcher aufweisenden Mehrlagenschaltungen, gekennzeichnet durch folgende Verfahrensschritte:

1. Vorbehandlung der Mehrlagenschaltung durch
   a) eine alkalische Entfettung und Spülen;
   b) eine Ablösung oxidischer Schichten von dem abzuätzenden Kupfer und Spülen;

2. vollständiges Abätzen der fehlerhaften Kupferleiterzüge (5) und Zurückätzen des Kupfers (4) an den Bohrlochwandungen mit zur Bohrlochmitte hin kontinuierlich abnehmender Ätzrate und Spülen;

3. Aufbringen einer Aktivierungsschicht (6) aus Kupfer auf die Oberfläche des Substrats (1) und auf die an diese angrenzenden Teile der Oberfläche der Bohrlochwandungen (4);

4. Aufwachsen von Kupferleiterzügen (7) auf durch eine Photoresistmaske definierten Oberflächenbereichen der Aktivierungsschicht (6) nach der Additivtechnik und von Kupfer auf der gesamten Oberfläche (4) der Bohrlochwandungen.

2. Verfahren nach Anspruch 1, dadurch gekennzeichnet, dass die Reinigung der Mehrlagenschaltung nach 1.a) mit einer alkalischen Lösung auf der Basis von Natrium-m-silicat mit einem Gehalt an Natriumlaurylsulfat und Diglykol während 2 Minuten bei etwa 65°C durchgeführt wird.

3. Verfahren nach Anspruch 1, dadurch gekennzeichnet, dass die Ablösung von Kupferoxid von dem abzuätzenden Kupfer nach 1.b) mit 25 Vol.%iger Salzsäure erfolgt.

4. Verfahren nach Anspruch 1, dadurch gekennzeichnet, dass das Abätzen der fehlerhaften Leiterzüge und des Kupfers von den Bohrlochwandungen nach 2. mit einer salzsauren Kupfer-II-chloridlösung erfolgt.

5. Verfahren nach den Ansprüchen 1 und 4, dadurch gekennzeichnet, dass während des Ätzens Luft vom Boden der Wanne durch das Ätzbad perlt und die Mehrlagenschaltungen eine alternierende Bewegung ausführen.

6. Verfahren nach den Ansprüchen 4 und 5, dadurch gekennzeichnet, dass die zu ätzenden Mehrlagenschaltungen in der Weise in das salzsaure Kupfer-II-chloridätzbad eingebracht werden, dass die Bohrlöcher im rechten Winkel zur Badströmung und zur Bewegungsrichtung der Mehrlagenschaltungen angeordnet sind, damit die Ätzrate des Kupfers in den Bohrungen zur Bohrungsmitte hin auf 0 abfällt.

7. Verfahren nach einem oder mehreren der Ansprüche 4 bis 6, dadurch gekennzeichnet, dass das Ätzen mit der salzsauren Kupfer-II-chloridlösung bei Raumtemperatur erfolgt.

8. Verfahren nach Anspruch 1, dadurch gekennzeichnet, dass zwischen den einzelnen Reinigungs- und Ätzschritten 1.a), b) und nach dem Ätzschritt 2. eine Fliessspülung mit deionisiertem Wasser durchgeführt wird.

9. Verfahren nach Anspruch 1, dadurch gekennzeichnet, dass die Aktivierungsschicht (6) mittels magnetfeldunterstützender Hochleistungskathodenzerstäubung auf das Substrat (1) und auf die Oberfläche der Bohrlochwandungen aufgebracht wird.

10. Verfahren nach Anspruch 9, dadurch gekennzeichnet, dass die Aktivierungsschicht (6) mit einer Sputterrate von 1,0 bis 1,5 nm/s bis zu einer Schichtdicke von 500 nm aufgebracht wird.

11. Verfahren nach den Ansprüchen 1, 9 und 10, dadurch gekennzeichnet, dass die Aktivierungsschicht (6) vollautomatisch in einer Durchlaufanlage aufgebracht wird und durch Anwendung von zwei Kathoden auf Vorder- und Rückseite der Mehrlagenschaltung gleichzeitig erfolgt.

12. Verfahren nach den Ansprüchen 1 und 9 bis 11, dadurch gekennzeichnet, dass die Bohrlöcher bis zu einem Aspektverhältnis von etwa 3:1, d.h. bis zu einer Tiefe, die etwa dem dreifachen Bohrlochdurchmesser entspricht, verkupfert werden.

## Claims

1. Method of renewing defective copper conductors (5) on the external planes of multilayer circuits comprising a substrate (1) and borings, characterized by the following process steps:
1. pre-processing of the multilayer circuit by
   a) alkaline degreasing and rinsing;
   b) removing of oxidic layers from the copper to be etched, and rinsing;
2. complete etching-off of the defective copper conductors (5), and back-etching of the copper (4) on the boring walls, with an etching rate continuously decreasing toward the boring center, and rinsing;
3. applying an activating layer (6) of copper on the surface of the substrate (1), and on the adjacent parts of the surface of the boring walls (4);
4. growing of copper conductors (7) on surface regions of the activating layer (6) which are defined by a photoresist mask, following the additive technique, and of copper on the entire surface (4) of the boring walls.

2. Method as claimed in claim 1, characterized in that the multilayer circuit is cleaned for 2 minutes at approximately 65°C in accordance with 1.a) above, with an alkaline solution on the basis of sodium-m-silicate with a content of sodium laurylsulphate and diglycol.

3. Method as claimed in claim 1, characterized in that the copper oxide is removed from the copper to be etched in accordance with 1.b), with 25 volume percent hydrochlorid acid.

4. Method as claimed in claim 1, characterized in that the defective conductors and the copper of the boring walls are etched-off in accordance with 2 above, with a hydrochloric copper-II-chloride solution.

5. Method as claimed in any one of claims 1 to 4, characterized in that during etching air is bubbling through the bath from the bottom of the tub, and the multilayer circuits execute an alternating movement.

6. Method as claimed in any one of claims 4 and 5, characterized in that the multilayer circuits to be etched are immersed in the hydrochloric copper-II-chloride etching bath in such a manner that the borings are arranged at right angles to the bath flow, and to the direction of movement of the multilayer circuits so that the copper etching in the borings decreases to 0 toward the boring center.

7. Method as claimed in one or several of claims 4 to 6, characterized in that the etching takes place with the hydrochloric copper-II-chloride solution at room temperature.

8. Method as claimed in claim 1, characterized in that between the individual cleaning and etching steps 1.a), b), and after etching step 2. there follows rinsing in flowing deionized water.

9. Method as claimed in claim 1, characterized in that the activating layer (6) is applied on the substrate (1) and the surface of the boring walls by means of magnetic field-supported high rate cathode sputtering.

10. Method as claimed in claim 9, characterized in that the activating layer (6) is applied by means of a sputter rate of 1.0 to 1.5 nm/s up to a layer thickness to 500 nm.

11. Method as claimed in any one of claims 1, 9 and 10, characterized in that the activating layer (6) is applied fully automatically in a continuous system, and that it is realized simultaneously due to the use of two cathodes on front and back of the multilayer circuit.

12. Method as claimed in any one of claims 1 and 9 to 11, characterized in that the borings are copper-coated to an aspect ratio of approximately 3:1, i.e. down to a depth which corresponds to approximately the triple boring diameter.

## Revendications

1. Procédé pour régénérer des voies conductrices en cuivre défectueuses (5) situées sur les plans extérieurs de circuits à couches multiples comportant un substrat (1) et des perçages, caractérisé par les phases opératoires suivantes:
1. prétraitement du circuit à couches multiples par

a) un dégraissage alcalin et un lavage;

b) un enlèvement, par dissolution, de couches oxydées à partir du cuivre devant être éliminé par corrosion et lavage;

2. elimination complète par corrosion des voies conductrices en cuivre défectueuses (5) et rétro-corrosion du cuivre (4) au niveau des parois des perçages avec une vitesse de corrosion diminuant de façon continue en direction du centre des perçages, et lavage;

3. dépôt d'une couche d'activation (6) constituée par du cuivre sur la surface du substrat (1) et sur les parties, jouxtant cette surface, de la surface des parois (4) des perçages;

4. croissance de voies conductrices en cuivre (7) sur des régions superficielles, définies par un masque de résine photosensible, de la couche d'activation (6) conformément à la technique additive et croissance de cuivre sur l'ensemble de la surface (4) des parois des perçages;

2. Procédé selon la revendication 1, caractérisé en ce que le nettoyage du circuit à couches multiples conformément à 1.a) s'effectue avec une solution alcaline à base de m-silicate de sodium possédant une teneur en laurylsulfonate de sodium et de diglycol pendant 2 minutes à environ 65°C.

3. Procédé selon la revendication 1, caractérisé en ce que l'élimination, par dissolution, de l'oxyde de cuivre devant être éliminé par corrosion selon 1.b) est réalisé avec de l'acide chlorhydrique à 25% en volume.

4. Procédé selon la revendication 1, caractérisé en ce que l'élimination par corrosion des voies conductrices défectueuses et du cuivre, des parois des perçages selon 2. est réalisée à l'aide d'une solution chlorhydrique de chlorure cuivrique.

5. Procédé selon les revendications 1 et 4, caractérisé en ce que pendant la corrosion, de l'air circule sous la forme de fines bulles à travers le bain corrosif, à partir du fond de la cuve et que les circuits à couches multiples sont soumis à un déplacement alternatif.

6. Procédé selon les revendications 4 et 5, caractérisé en ce qu'on introduit les circuits à couches multiples devant être corrodés dans le bain d'acide chlorhydrique de chlorure cuivrique de telle sorte que les perçages sont disposés perpendiculairement à la circulation du bain et à la direction de déplacement du circuit à couches multiples afin que la vitesse de corrosion du cuivre dans les perçages tombe à 0 jusqu'au centre des perçages.

7. Procédé selon une ou plusieurs des revendications 4 à 6, caractérisé en ce que la corrosion est réalisée avec la solution chlorhydrique de chlorure cuivrique à la température ambiante.

8. Procédé selon la revendication 1, caractérisé en ce qu'on exécute un lavage à circulation avec de l'eau désionisée entre les phases individuelles de nettoyage et de corrosion 1.a), b) et après la phase de corrosion 2.

9. Procédé selon la revendication 1, caractérisé en ce que la couche d'activation (6) est déposée au moyen d'une pulvérisation cathodique de grande puissance, assistée par un champ magnétique, sur le substrat (1) et sur la surface des parois des perçages.

10. Procédé selon la revendication 9, caractérisé en ce que la couche d'activation (6) est déposée avec une vitesse de pulvérisation comprise entre 1 et 1,5 nm/s jusqu'à une épaisseur de couche de 500 nm.

11. Procédé selon les revendications 1, 9 et 10, caractérisé en ce que la couche d'activation (6) est déposée d'une manière entièrement automatique dans une installation à traversée et que le dépôt s'effectue simultanément grâce à l'utilisation de la cathode sur la face avant et la face arrière du circuit à couches multiples.

12. Procédé selon les revendications 1 et 9 à 11, caractérisé en ce que le cuivrage des perçages s'effectue jusqu'à l'obtention d'un rapport d'élancement d'environ 3:1, c'est-à-dire jusqu'à une profondeur qui correspond approximativement au triple du diamètre des perçages.

**FIG.1A**

**FIG.1B**

**FIG.1C**